## Europäisches Patentamt

## European Patent Office

## Office européen des brevets

(19)

(11) Veröffentlichungsnummer: **0 037 105**
**B1**

(12) # EUROPÄISCHE PATENTSCHRIFT

(45) Veröffentlichungstag der Patentschrift:
**10.06.87**

(51) Int. Cl.⁴: **H 01 L 29/78,** H 01 L 29/10

(21) Anmeldenummer: **81102344.9**

(22) Anmeldetag: **27.03.81**

(54) **Feldeffekttransistor.**

(30) Priorität: **28.03.80 DE 3012185**

(43) Veröffentlichungstag der Anmeldung:
**07.10.81 Patentblatt 81/40**

(45) Bekanntmachung des Hinweises auf die Patenterteilung:
**10.06.87 Patentblatt 87/24**

(84) Benannte Vertragsstaaten:
**DE**

(56) Entgegenhaltungen:
**FR-A-2 349 958**

**INTERNATIONAL ELECTRON DEVICES MEETING,
5.-7. Dezember 1977, Seiten 399-401, Washington
D.C., USA, J. TIHANYI et al.: "DIMOS - A novel IC
technology with submicron effective channel
MOSFETs"
ELECTRON DESIGN, Band 27, Nr. 12, Juni 1976,
Seiten 36-40, Rochelle Park, USA, H.W. COLLINS et
al.: "HEXFET, a new power technology, cuts onresistance, boosts ratings"
SIEMENS FORSCHUNGS- UND ENTWICKLUNGS-
BERICHTE, Band 9, Nr. 4, 1980, Seiten 181-189,
Berlin, DE., J. TIHANYI: "A qualitative study of the
DC performance of SIPMOS transistors"
RADIO MENTOR ELECTRONIC, Band 46, Nr. 3, März
1980, Seite 68, München, DE., "SIPMOS Aktoren für
die Mikroelectronic"**

(73) Patentinhaber: **Siemens Aktiengesellschaft Berlin
und München, Wittelsbacherplatz 2, D-8000
München 2 (DE)**

(72) Erfinder: **Stengl, Jens Peer, Ing. grad.,
Guntherstrasse 13/III, D-8000 München 19 (DE)**
Erfinder: **Tihanyi, Jenö, Dr., Wolfratshauser
Strasse 179b, D-8000 München 71 (DE)**

## Beschreibung

Die Erfindung bezieht sich auf einen Feldeffekttransistor mit einem n-leitenden Substrat, mit einer p-leitenden Zone, die planar in das Substrat eingebettet ist, mit einer n-leitenden zweiten Zone, die planar in die erste Zone eingebettet ist, wobei die pn-Übergänge zwischen der ersten und zweiten Zone bzw. zwischen der ersten Zone und dem Substrat an die Substratoberfläche treten, mit mindestens einer zwischen den genannten pn-Übergängen liegenden, gerade ausgebildete Abschnitte aufweisenden Kanalzone, wobei der pn-Übergang zwischen der ersten und zweiten Zone an der Substratoberfläche die Gestalt eines Polygons hat, und mit einer mindestens die Kanalzone überdeckenden, gegen die Substratoberfläche isolierten Steuerelektrode.

Solche Feldeffekttransistoren sind bereits beschrieben worden (vgl. FR-A-2 349 958). Bei ihnen ist bei Anlegen einer in Durchlaßrichtung gepolten Spannung zwischen Quelle (source) und Senke (drain) der zwischen erster Zone und Substrat liegende pn-Übergang in Sperrichtung vorgespannt. Aufgrund der durch die Anwendung der Planartechnik vorhandenen Krümmung der Raumladungszone zwischen erster Zone und Substrat kommt es an den Krümmungen zu Feldstärkeerhöhungen, die eine Ladungsträgermutiplikation hervorrufen. Die Multiplikation im Substrat ist prinzipiell unvermeidbar und führt zu einem steilen Anstieg des Transistorstroms mit zunehmender Spannung.

Bildet man den in Sperrichtung vorgespanten pn-Übergang zusätzlich an der Oberfläche im Bereich der Kanalzone, daß heißt der Inversionsschicht, ungünstig aus, so kann es auch im Bereich der Substratoberfläche zu einer übermäßigen Multiplikation kommen, die einen Steilanstieg des Stroms durch den Feldeffekttransistor verursacht. Dieser Anstieg erfolgt immer bei Spannungswerten, die kleiner sind als diejenigen, bei dem der Anstieg im Substratinnern erfolgen würde.

Der Erfindung liegt die Aufgabe zugrunde, einen FET gemäß der eingangs erwähnten Gattung so weiterzubilden, daß der Steilanstieg an der Substratoberfläche erst bei Spannungswerten erfolgt, die denjenigen für einen Steilanstieg im Substratinneren zumindest stark angenähert ist.

Die Erfindung ist dadurch gekennzeichnet, daß jeweils zwischen zwei der Abschnitte ein Berich vom gleichen Leitungstyp wie die Kanalzone liegt und daß dieser Bereich größere Breite und/oder höhere Dotierung als die Kanalzone hat.

Weiterbildungen der Erfindung sind Gegenstand der Unteransprüche.

Die Erfindung wird anhand einiger Ausführungsbeispiele in Verbindung mit den Figuren näher erläutert. Es zeigen: (es folgt Seite 3 der bisherigen Beschreibung)

Fig. 1 die Aufsicht auf ein erstes Ausführungsbeispiel eines Vertikal-MIS-FET mit n-leitendem Kanal,

Fig. 2 den Schnitt durch den FET nach Fig. 1 entlang der Linie II-II,

Fig. 3 die Aufsicht auf ein weiteres Ausführungsbeispiel mit n-leitendem Kanal,

Figuren 4 und 3 Schnitte durch das Ausführungsbeispiel nach Fig. 3 entlang der Linien IV-IV bzw. V-V,

Fig. 6 die Aufsicht auf ein drittes Ausführungsbeispiel eines FET mit n-leitendem Kanal,

Fig. 7 die Aufsicht auf ein viertes Ausführungsbeispiel eines FET mit n-leitendem Kanal und

Fig. 8 die Aufsicht auf ein Ausführungsbeispiel eines FET mit p-leitendem Kanal.

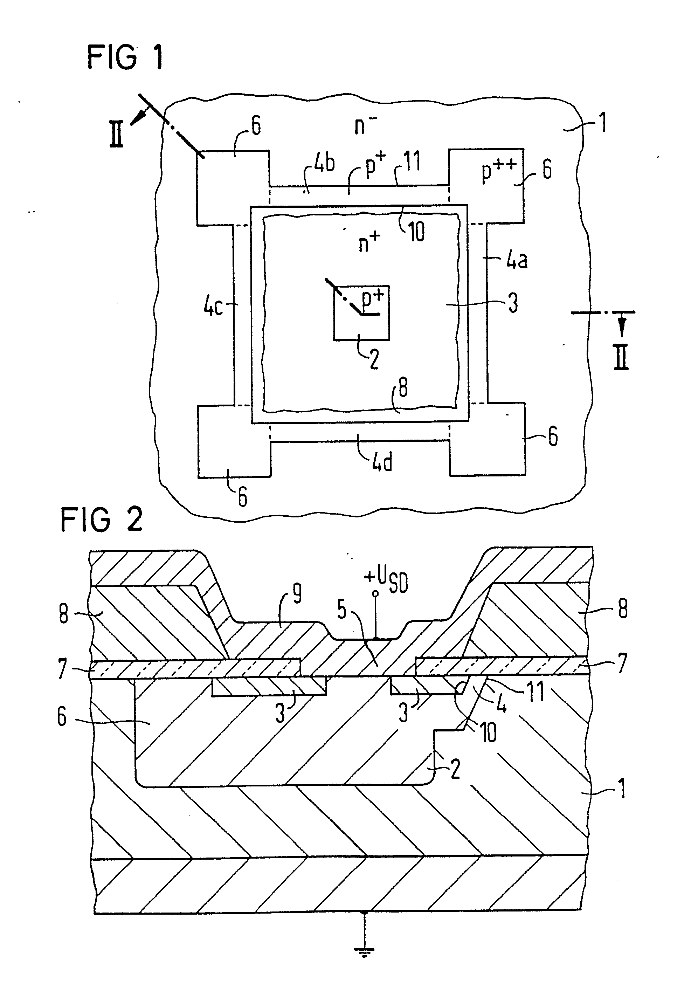

In Fig. 1 und Fig. 2 ist ein Ausschnitt aus einem Vertikal-MIS-FET dargestellt, der auf einem n-leitenden Substrat 1 angeordnet ist. In dieses Substrat, das die Senke (drain) des FET bildet, ist eine erste Zone 2 mit p-Leitfähigkeit eingebettet. Diese Zone weist eine Kanalzone 4 gleichen Leitfähigkeitstyps auf, die durch Ionenimplantation hergestellt ist. Sie ist relativ schwach dotiert. Die Zone 2 selbst ist üblicherweise eindiffundiert und relativ stark dotiert. In die erste Zone 2 ist eine zweite Zone 3, die Quelle (source), vom ersten Leitfähigkeitstyp (n-leitend) eingebettet. Die zweite Zone 3 kann implantiert oder diffundiert sein. Die Substratoberfläche ist mit einer Isolierschicht 7, z. B. aus Siliziumdioxid $SiO_2$ bedeckt und läßt nur ein Kontaktloch 5 frei. Auf der Isolierschicht 7 sitzt eine Gateelektrode 8, die aus hochdotiertem polykristallinen Silizium bestehen kann. Sie hat eine abgeschrägte Flanke und dient als Maske bei der Implantation der Kanalzone 4 und ggf. der Zone 3. Die Steuerelektrode 8 ist in Fig. 1 der besseren Übersichtlichkeit halber durchsichtig dargestellt, wobei lediglich ihre auf der zweiten Zone 3 liegende Innenkante sichtbar ist. Die Isolierschicht 7 wurde in Fig. 1 zur besseren Übersichtlichkeit ganz weggelassen.

Zwischen der zweiten Zone 3 und der Kanalzone 4 liegt der pn-Übergang 10.

Die Kanalzone 4 liegt zwischen dem pn-Übergang 10 und einem pn-Übergang 11, der zwischen erster Zone 2 und dem Substrat 1 liegt. Die pn-Übergänge liegen an der Substratoberfläche parallel zueinander und sind gerade ausgebildet. Die Kanalzone ist in vier Abschnitte 4a, 4b, 4c und 4d unterteilt, zwischen denen je ein stark p-dotierter Bereich 6 liegt. Dieser Bereich 6 ist Teil der ersten Zone 2. Er hängt mit der Kanalzone 4 zusammen und hat auch gleichen Leitfähigkeitstyp wie diese, ist aber höher dotiert.

Wird an den FET eine Spannung in Durchlaßrichtung angelegt, so bedeutet dies, daß die Zone 2 an negativer und das Substrat 1 an positiver Polarität liegt. Es bildet sich dann beiderseits des pn-Übergangs 11 eine Raumladungszone aus. Diese Raumladungszone folgt an der Oberfläche in etwa dem Verlauf der pn-Übergänge 10 und 11. Auf der Seite der negativ-dotierten Zone, dem Substrat 1, grenzt die Kante 11 unter einem Winkel von 180° an das Substrat. Damit kann an keiner Stelle der Kanalzone 4a bis 4d eine Feldstärkeerhöhung auftreten. Damit wird die Ladungsträgermultiplikation an der Oberfläche stark vermindert und zumindest an die Werte im Substratinneren angenähert. In den Bereichen 6 bildet sich auch bei Anlegen einer Steuerspannung keine Inversionsschicht aus, da die Dotierung der Bereiche 6 viel höher als die der Kanalzone 4 ist. Außerdem ist ihre Breite viel größer. Es kann daher im Bereich 6 kein Strom fließen und eine Ladungsträgermultiplikation unterbleibt.

Zur Erzielung größerer Leistung werden die in den Figuren 1 und 2 dargestellten Zellen zweckmäßigerweise in einer größeren Anzahl auf dem Substrat 1 integriert und parallelgeschaltet. Die Zonen 2 und 3 aller Zellen können durch eine Metallschicht 9 verbunden werden, während das Substrat 1, mit einer großflächigen Metallelektrode kontaktiert wird. Zur Raumersparnis können die Strukturen so dicht gepackt werden, daß die einander benachbarten Bereiche 6 von vier im Quadrat angeordneten Zellen eine einzige Zone bilden.

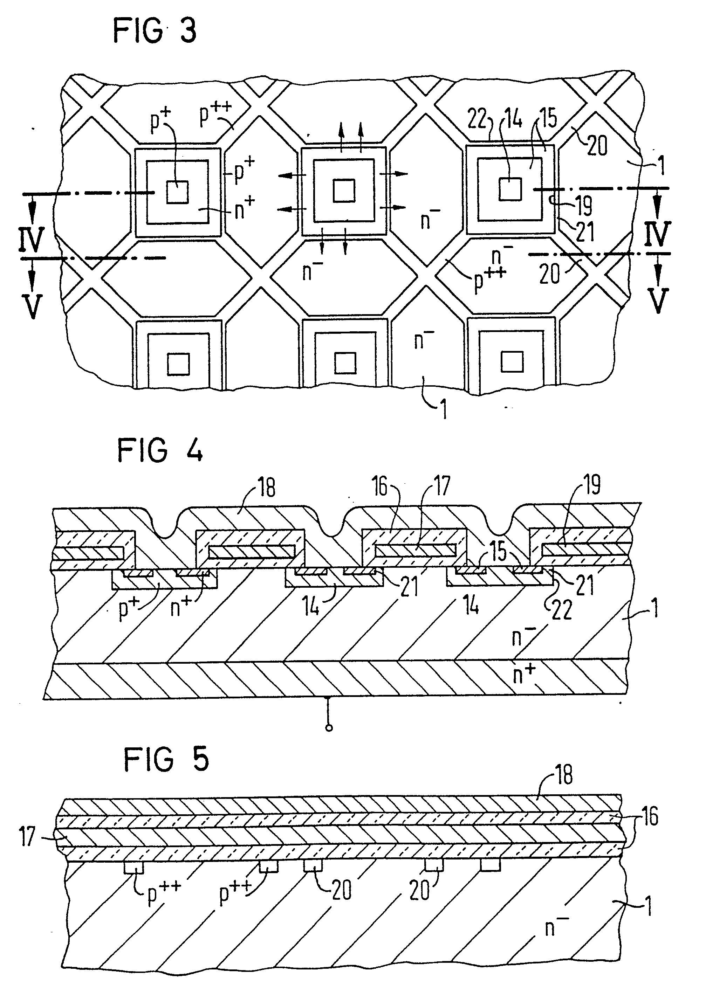

In den Figuren 3 bis 3 ist eine Abwandlung des FET nach den Figuren 1 und 2 dargestellt. In das n-leitende Substrat 1 sind erste p-leitende Zonen 14 zum Beispiel durch Planardiffusion eingebettet. Sie sind quadratisch, können jedoch auch rechteckig sein. In diese ersten Zonen sind zweite Zonen 15 (Quelle) eingebettet, die n-leitend sind. Diese können durch Planardiffusion oder durch Ionenimplantation hergestellt sein. Der pn-Übergang zwischen der ersten Zone 14 und dem Substrat 1 ist mit 22 bezeichnet. Zwischen der Kante 22 und der zweiten Zone 15 liegt eine Kanalzone 21. Zur Vermeidung der in Verbindung mit Fig. 1 und Fig. 2 erläuterten Erhöhung der Feldstärke zwischen dem n-dotierten Substrat und der p-dotierten Zone 14 im Bereich der Kanalzone 21 läuft die Zone 14 an den Ecken in relativ hochdotierte Stege 20 aus. Diese Stege 20 haben die gleiche Funktion wie die Bereiche 6 des FET nach Fig. 1. Sind, wie im Ausführungsbeispiel nach Fig. 3, eine Vielzahl von Zonen 14 in Form regelmäßiger Quadrate angeordnet, so sind jeweils die einander benachbarten Ecken der Zonen 14 durch zwei sich kreuzende Stege 20 miteinander verbunden. Diese Stege 20 bilden dann eine einzige zusammenhängende Zone.

Im Bereich der Ecken der Zone 14 ist die Dotierung zwischen der Zone 15 und dem Substrat 1 so groß, daß sich bei Anlegen einer Steuerspannung dort keine Inversionsschicht ausbilden kann. Damit fließt dort auch kein Strom und eine Ladungsträgermultiplikation wird an den Ecken vermieden.

Die Steuerelektrode ist in Fig. 4 mit 19 bezeichnet und besteht vorzugsweise aus hochdotiertem, polykristallinen Silizium. Sie überdeckt die zweiten Zonen 14 mindestens im Bereich der Kanalzonen 21. Eine Überdeckung der Stege 20 ist unschädlich. Die Steuerelektrode 17 ist gegen die Substratoberfläche durch eine Isolierschicht 16, z. B. aus Siliziumdioxid $SiO_2$, isoliert. Sie läßt Kontaktöffnungen frei, durch die die ersten Zonen 14 und die zweiten Zonen 13 durch eine Metallschicht 18 kontaktiert werden. In Fig. 3 ist die Steuerelektrode 17 und die Isolierschicht 16 sowie die Metallschicht 18 der besseren Übersichtlichkeit halber weggelassen. Lediglich die Kante 19 der Steuerelektrode 17 ist dargestellt.

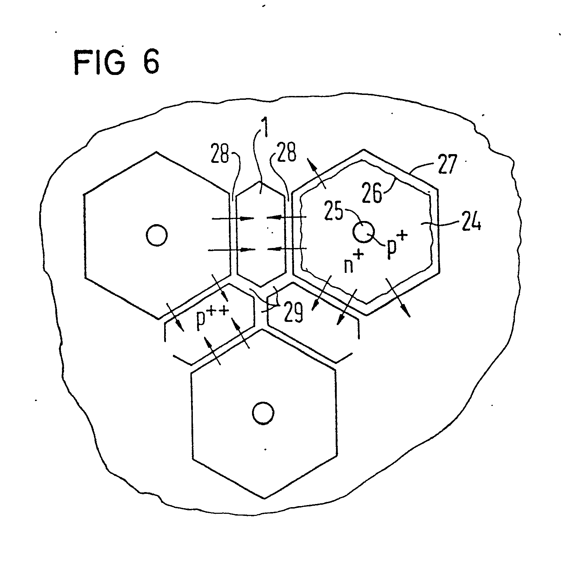

In Fig. 6 ist ein besonders raumsparendes Ausführungsbeispiel eines FET dargestellt. In ein n-leitendes Substrat 1 (Senke) sind erste p-leitende Zonen eingebettet. In diese ersten Zonen sind zweite Zonen 24 (Quelle) von regelmäßig sechseckiger Gestalt eingelagert. Diese weisen in der Mitte eine Öffnung 25 auf, durch die ein Teil der ersten p-Zone von oben sichtbar ist. Bestandteile der ersten Zone sind auch die Kanalzonen 28, die wie die ersten Zonen p-leitend sind. Die Kanten zwischen den Zonen 24 und den Kanalzonen 28 sind mit 27 bezeichnet Sie sind gerade ausgebildet. Die Ecken jeweils dreier in Form eines Dreiecks angeordneten sechseckigen ersten Zonen sind durch Stege 29 verbunden, die stark D-dotiert sind. Diese Stege 29 bilden zusammen eine dreistrahlige sternförmige, vorzugsweise stark p-dotierte Zone. Sie verhindert eine Ladungsträgermultiplikation im Bereich der Ecken an der Substratoberfläche. Die sechseckigen Zellen sind zum großen Teil von einer gegen die Substratoberfläche isolierten Steuerelektrode bedeckt, deren Kante mit 26 bezeichnet ist. Im übrigen wurde weder die Isolierschicht noch die Steuerelektrode dargestellt. Beim Betrieb des dargestellten FET kann ein Stromfluß nur an den geraden Kanten, wie durch die Pfeile dargestellt, stattfinden. Ein Stromfluß durch die Ecken der Sechsecke wird unterbunden, da hier der Bereich 29 wesentlich breiter und höher dotiert ist als die Kanalzone 28 und sich daher keine Inversionszone bilden känn. In Fig. 6 wurden nur drei Zellen dargestellt. Für größere Einheiten sind entsprechend viele Zeilen parallelzuschalten.

**Patentansprüche**

1. Feldeffekttransistor mit einem n-leitenden Substrat (1), mit einer p-leitenden ersten Zone (2), die planar in das Substrat eingebettet ist, mit einer n-leitenden zweiten Zone (3), die planar in die erste Zone eingebettet ist, wobei die pn-Übergänge (10, 11) zwischen der ersten und zweiten Zone bzw. zwischen der ersten Zone und dem Substrat an die Substratoberfläche treten, mit mindestens einer zwischen den genannten pn-Übergängen liegenden, gerade ausgebildete Abschnitte (4a, 4b, 4c, 4d) aufweisenden Kanalzone (4), wobei der pn-Übergang zwischen der ersten (2) und zweiten Zone (3) an der Substratoberfläche die Gestalt eines Polygons hat, und mit einer mindestens die Kanalzone überdeckenden, gegen die Substratoberfläche isolierten Steuerelektrode (8), dadurch gekennzeichnet, daß jeweils zwischen zwei der Abschnitte (4a bis d) ein Bereich (6) vom gleichen Leitungstyp wie die Kanalzone liegt und daß dieser Bereich (6) größere Breite und/oder höhere Dotierung als die Kanalzone hat.

2. FET nach Anspruch 1, dadurch gekennzeichnet, daß die Anzahl der Abschnitte (4a bis d) der Kanalzone (4) gleich der Anzahl der Seiten des Polygons ist.

3. FET nach Anspruch 1 oder 2, dadurch gekennzeichnet, daß in das Substrat (1) eine Vielzahl von ersten Zonen (2) eingebettet ist, daß die ersten Zonen (2) rechtwinklige Vierecke sind und in Form eines regelmäßigen Vierecks angeordnet sind, daß die Bereiche als Stege (20) ausgebildet sind, und daß die einander gegenüberliegenden Ecken der ersten Zonen (2) durch zwei sich x-förmig kreuzende, eine zusammenhängende Zone bildende Stege (20) verbunden sind.

4. FET nach Anspruch 1 oder 2, dadurch gekennzeichnet, daß in das Substrat eine Vielzahl von ersten Zonen (2) eingebettet ist, daß die ersten Zonen (2) regelmäßige Sechsecke sind, von denen mindestens je drei in einem regelmäßigen Dreieck angeordnet sind, daß die Bereiche als Stege (29) ausgebildet sind, und daß die einander gegenüberliegenden Ecken der drei Sechsecke durch die Stege (29) miteinander verbunden sind.

5. FET nach Anspruch 4, dadurch gekennzeichnet, daß die Stege (29) sternförmig miteinander verbunden sind.

## Claims

1. A field effect transistor having an n-conducting substrate (1), a p-conducting first zone (2) embedded in planar fashion into the substrate, an n-conducting second zone (3) embedded in planar fashion into the first zone, the pn-junctions (10, 11) between the first and second zones and between the first zone and the substrate respectively emerge at the substrate surface, at least one channel zone (4) which is located between the said pn-junctions and has straight sections (4a, 4b, 4c, 4d), the pn-junction between the first zone (2) and the second zone (3) having the shape of a polygon at the substrate surface, and a control electrode (8) which covers at least the channel zone and is insulated from the substrate surface, characterised in that a zone (6) of the same conductivity type as the channel zone is in each case located between two of the sections (4a to d); and that this zone (6) has a greater width and/or a higher doping level than the channel zone.

2. An FET as claimed in Claim 1, characterised in that the number of sections (4a to d) of the channel zone (4) is equal to the number of sides of the polygon.

3. An FET as claimed in Claim 1 or Claim 2, characterised in that a plurality of first zones (2) are embedded into the substrate (1); that the first zones (2) are rectangular quadrilaterals and are arranged in the form of a regular quadrilateral; that the zones consist of bridges (20); and that the diagonally opposite corners of the first zones (2) are joined by two bridges (20) which intersect in X-formation and form a cohesive zone.

4. An FET as claimed in Claim 1 or Claim 2, characterised in that a plurality of first zones (2) are embedded into the substrate; that the first zones (2) are regular hexagons, of which at least three are arranged in the form of a regular triangle; that the zones consist of bridges (29) and that the mutually opposite corners of the three hexagons are joined to one another by the bridges (29).

5. An FET as claimed in Claim 4, characterised in that the bridges (29) are joined to one another in a star formation.

## Revendications

1. Transistor à effet de champ comportant un substrat (1) conducteur du type n, une première zone (2) conductrice du type p et qui est insérée selon le mode planar dans le substrat, une seconde zone (3) conductrice du type n, qui est insérée selon le mode planar dans la première zone, auquel cas les jonctions pn (10, 11) entre la première et seconde zone ou entre la première zone et le substrat sont situées au niveau de la surface de ce dernier, et comportant au moins une zone de canal (4) comportant des sections rectilignes (4a, 4b, 4c, 4d) situées entre lesdites jonctions pn, la jonction pn entre la première zone (2) et la seconde zone (3) au niveau de la surface du substrat possédant la forme d'un polygône, et comportant au moins une électrode de commande (8) recouvrant la zone de canal et isolée par rapport à la surface du substrat, caractérisé par le fait qu'une zone (6) possédant le même type de conductivité que la zone de canal est située respectivement entre deux des sections (4a à d) et que cette zone (6) possède une largeur supérieure et/ou un dopage supérieur à la zone de canal.

2. FET suivant la revendication 1, caractérisé par le fait que le nombre des sections (4a à 4d) de la zone de canal (4) est égale au nombre des côtés du polygone.

3. FET suivant la revendication 1 ou 2, caractérisé par le fait qu'une multiplicité de premières zones (2) est insérée dans le substrat (1), que les premières zones (2) sont des quadrilaires rectangles et sont disposées sous la forme d'un quadrilataire régulier, que les zones sont réalisées sous la forme de barrettes (20) et que les sommets, qui sont situés respectivement en vis-à-vis, des premières zones (2) sont reliés par l'intermédiaire de deux barrettes (20) qui se croisent en forme de x et forment une zone continue.

4. FET suivant la revendication 1 ou 2, caractérisé par le fait qu'une multiplicité de premières zones (2) est insérée dans le substrat, que les premières zones (2) sont des hexagones réguliers, parmi lesquels au moins trois d'entre eux sont disposés selon un triangle régulier, que les zones sont réalisées sous la forme de barrettes (29) et que les sommets, qui sont situés respectivement en vis-à-vis, des trois hexagones sont reliés entre eux par des barrettes (29).

5. FET suivant la revendication 4, caractérisé par le fait que les barrettes (29) sont reliées entre elles selon une disposition en étoile.

FIG 1

FIG 2

# FIG 3

# FIG 4

# FIG 5

# FIG 6